# EUROPEAN PATENT APPLICATION

(11) **EP 4 593 244 A1**
(43) Date of publication of application: **30.07.2025**
(21) Application number: 24193181.5
(22) Date of filing: 06.08.2024
(51) Int. Cl.: H02J 9/06, H02J 3/00, H02M 1/32, G01R 31/40

(54) **FAULT DETECTION AND PROCESSING METHOD AND APPARATUS FOR UNINTERRUPTIBLE POWER SUPPLY, AND CONTROLLER**

(30) Priority: 24.01.2024 CN 202410103091
(71) Applicant: Vertiv Tech Co., Ltd., Guangdong 518055 (CN)
(72) Inventor: XU, Wei, Shenzhen 518055 (CN); CHEN, Peng, Shenzhen 518055 (CN)
(74) Representative: Morrall, Jonathan Ian McLachlan

(57) **Abstract**

A fault detection and processing method and apparatus for an uninterruptible power supply, and a controller are provided. The current at at least one sampling point to-be-tested in at least one fault circuit to-be-detected in the uninterruptible power supply is sampled, and the sampled current is compared with a corresponding fault current range to determine a faulty device causing an abnormal current in the fault circuit to-be-detected. Based on the faulty switching device, the operation state of a rectification and discharge multiplexing circuit is adjusted in order to cut off the fault circuit where the faulty switching device is located, and to timely stop the impact of the fault current on the uninterruptible power supply, thereby ensuring the reliability of the power supply system.

## Description

The present application claims priority to Chinese Patent Application No. 202410103091.5, titled "FAULT DETECTION AND PROCESSING METHOD AND APPARATUS FOR UNINTERRUPTIBLE POWER SUPPLY, AND CONTROLLER", filed on January 24, 2024 with the China National Intellectual Property Administration, which is incorporated herein by reference in its entirety.

### FIELD

The present disclosure relates to the field of uninterruptible power supplies, and in particular to a fault detection and processing method and apparatus for an uninterruptible power supply, and a controller.

### BACKGROUND

Uninterruptible power supply (UPS) is a device used in a data center to provide stable electrical energy to poststage devices. A UPS includes a battery pack, a rectification and discharge multiplexing circuit, an inverter circuit, a battery charging circuit, and a switching device. The switching device, the battery switching device, and the rectification and discharge multiplexing circuit are electrically connected to provide energy stored in the battery to the rectification and discharge multiplexing circuit in a case that the UPS operates in a battery mode, so that the rectification and discharge multiplexing circuit may provide electrical energy to the inverter circuit, thereby improving device utilization.

The uninterruptible power supply includes at least one mains switching device and at least one battery switching device. The battery switching device is connected in series as a switching device between an input terminal of the rectification and discharge multiplexing circuit and a terminal of the battery pack. The mains switching device is connected in series between a mains input terminal of the uninterruptible power supply and the input terminal of the rectification and discharge multiplexing circuit. In a case that any one of the switching devices is short circuited and the other one of the switching devices electrically connected to the switching device is closed (for example, the mains switching device is closed and the battery switching device connected to the mains switching device is short circuited), a short-circuit circuit is formed between the battery pack and the mains. The short-circuit circuit passes through a bus capacitor. A short-circuit voltage formed by superimposing a voltage of the battery pack and a voltage of the mains electricity far exceeds a rated voltage of the bus capacitor, resulting in the failure of the bus capacitor and power failure of the poststage devices of the UPS, thereby reducing reliability of the UPS.

### SUMMARY

To solve the above technical problems, a fault detection and processing method for an uninterruptible power supply, a fault detection and processing apparatus for an uninterruptible power supply, and a controller are provided according to the present disclosure.

In a first aspect, a fault detection and processing method for an uninterruptible power supply is provided according to the present disclosure. The method is applied to the uninterruptible power supply. The uninterruptible power supply includes at least one uninterruptible power supply module. Each of the at least one uninterruptible power supply module includes: a rectification and discharge multiplexing circuit, a battery, at least one mains switching device and at least one battery switching device. A first end of each of the at least one mains switching device is coupled to a mains input terminal of the uninterruptible power supply. A second end of each of the at least one mains switching device is electrically connected to the rectification and discharge multiplexing circuit and a first end of a corresponding one of the at least one battery switching device. A second end of each of the at least one battery switching device is coupled to the battery. The method includes:
obtaining a value of a current at at least one sampling point to-be-tested in the uninterruptible power supply, wherein the at least one sampling point to-be-tested is located in at least one fault circuit to-be-detected of the uninterruptible power supply, and each of the at least one fault circuit to-be-detected includes at least one mains switching device and at least one battery switching device;
determining that at least one switching device in the fault circuit to-be-detected is faulty, in a case that the value of the current is within a fault current range corresponding to the at least one sampling point to-be-tested; and
adjusting an operation state of the rectification and discharge multiplexing circuit based on the faulty switching device, to cut off the faulty circuit where the faulty switching device is located.

In the above technical solution, the current at at least one sampling point to-be-tested in at least one fault circuit to-be-detected in the uninterruptible power supply is sampled, and the sampled current is compared with a corresponding fault current range to determine the faulty device causing the abnormal current in the fault circuit to-be-detected. Based on the faulty switching device, the operation state of the rectification and discharge multiplexing circuit is adjusted to cut off the fault circuit where the faulty switching device is located, and to timely stop the impact of the fault current on the uninterruptible power supply, thereby ensuring the reliability of the power supply system.

In a second aspect, a fault detection and processing apparatus for an uninterruptible power supply is provided according to the present disclosure. The apparatus includes: an obtaining module and a processing module. The obtaining module is configured to obtain a value of a current at at least one sampling point to-be-tested in the uninterruptible power supply, wherein the at least one sampling point to-be-tested is located in at least one fault circuit to-be-detected of the uninterruptible power supply, and the at least one fault circuit to-be-detected includes at least one mains switching device and at least one battery switching device. The processing module is configured to determine that at least one switching device in the fault circuit to-be-detected is faulty, in a case that the value of the current is within a fault current range corresponding to the at least one to-be-tested sampling point. The processing module is further configured to adjust an operation state of the rectification and discharge multiplexing circuit based on the faulty switching device, to cut off the circuit where the faulty switching device is located.

In a third aspect, a controller is provided according to the present disclosure. The controller includes: a processor, and a memory connected in communication with the processor. The memory stores computer executable instructions. The processor is configured to, when executing the computer executable instructions, perform the method in the first aspect.

A fault detection and processing method for an uninterruptible power supply, a fault detection and processing apparatus for an uninterruptible power supply, and a controller are provided according to the present disclosure. The uninterruptible power supply includes at least one uninterruptible power supply module. Each of the at least one uninterruptible power supply module includes: a rectification and discharge multiplexing circuit, a battery, at least one mains switching device and at least one battery switching device. A first end of each of the at least one mains switching device is coupled to a mains input terminal of the uninterruptible power supply. A second end of each of the at least one mains switching device is electrically connected to the rectification and discharge multiplexing circuit and a first end of a corresponding one of the at least one battery switching device. A second end of each of of the at least one battery switching device is coupled to the battery. The current at at least one sampling point to-be-tested in at least one fault circuit to-be-detected in the uninterruptible power supply is sampled, and the sampled current is compared with a corresponding fault current range to determine the faulty device causing the abnormal current in the fault circuit to-be-detected. Based on the faulty switching device, the operation state of the rectification and discharge multiplexing circuit is adjusted to cut off the fault circuit where the faulty switching device is located, timely stopping the impact of the fault current on the uninterruptible power supply, thereby ensuring the reliability of the power supply system.

### BRIEF DESCRIPTION OF THE DRAWINGS

The accompanying drawings herein are incorporated into the specification and form a part of this specification, illustrating embodiments of the present disclosure and used together with the specification to explain the principles of the present disclosure.
Figure 1 is a schematic structural diagram of an uninterruptible power supply according to an exemplary embodiment of the present disclosure;
Figures 2A to 2C are schematic structural diagrams of an uninterruptible power supply according to another exemplary embodiment of the present disclosure;
Figure 3 is a flowchart of a fault detection and processing method for an uninterruptible power supply according to an exemplary embodiment of the present disclosure;
Figure 4 is a schematic diagram showing a position of a detection point according to an exemplary embodiment of the present disclosure;
Figure 5 is a flowchart of a fault detection and processing method for an uninterruptible power supply according to another exemplary embodiment of the present disclosure;
Figure 6 is a flowchart of a fault detection and processing method for an uninterruptible power supply according to another exemplary embodiment of the present disclosure;
Figure 7 is a schematic diagram showing a position of a detection point according to another exemplary embodiment of the present disclosure;
Figure 8 is a flowchart of a fault detection and processing method for an uninterruptible power supply according to another exemplary embodiment of the present disclosure;
Figure 9 is a schematic diagram showing a position of a detection point according to another exemplary embodiment of the present disclosure;
Figure 10 is a flowchart of a fault detection and processing method for an uninterruptible power supply according to another exemplary embodiment of the present disclosure;
Figure 11 is a flowchart of a fault detection and processing method for an uninterruptible power supply according to another exemplary embodiment of the present disclosure;
Figure 12 is a schematic diagram showing a position of a detection point according to another exemplary embodiment of the present disclosure;
Figure 13 is a flowchart of a fault detection and processing method for an uninterruptible power supply according to another exemplary embodiment of the present disclosure;
Figure 14 is a schematic diagram showing a position of a detection point according to another exemplary embodiment of the present disclosure;
Figure 15 is a flowchart of a fault detection and processing method for an uninterruptible power supply according to another exemplary embodiment of the present disclosure;
Figure 16 is a flowchart of a fault detection and processing method for an uninterruptible power supply according to another exemplary embodiment of the present disclosure;
Figure 17 is a schematic structural diagram of a fault detection and processing apparatus for an uninterruptible power supply according to an exemplary embodiment of the present disclosure; and
Figure 18 is a schematic structural diagram of a controller according to an embodiment of the present disclosure;

The above drawings show the embodiments of the present disclosure, and detailed descriptions are provided below. These drawings and descriptions are not intended to limit the scope of the present disclosure, but to illustrate the concept of the present disclosure to those skilled in the art with reference to the embodiments.

### DETAILED DESCRIPTION

The exemplary embodiments are explained in detail, and examples are shown in the accompanying drawings. When the following description involves drawings, unless otherwise indicated, the same reference numerals in different drawings represent the same or similar elements. The following exemplary embodiments do not include all the embodiments consistent with the present disclosure. On the contrary, the following embodiments only show examples of apparatus and method consistent with some aspects of the present disclosure as detailed in the attached claims.

Data center, commonly known as computer room, includes a computer system, a communication system, a storage system, an environmental control device, a monitoring device, and various security devices. Stable power supply for a data center is a prerequisite for the stable operation of the data center. Therefore, an uninterruptible power supply generally arranged in the data center. The uninterruptible power supply is electrically connected between mains electricity and electrical devices in the data center to provide stable and continuous power to various consumers.

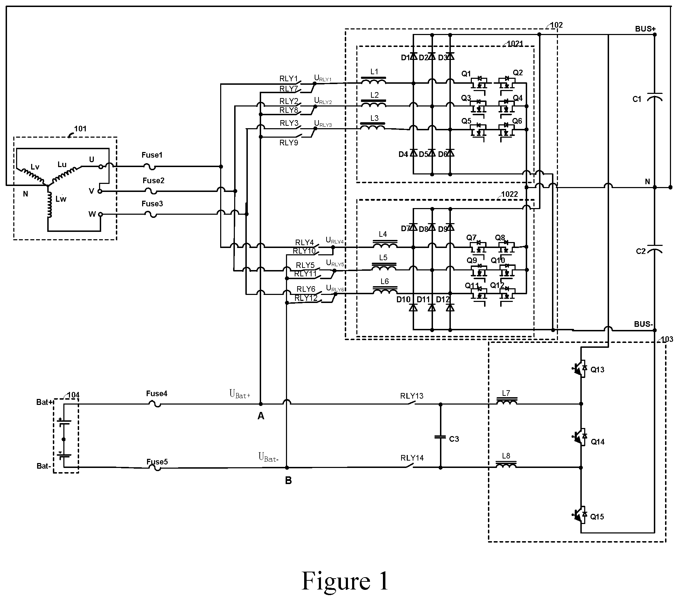

Figure 1 is a schematic structural diagram of a circuit of an uninterruptible power supply according to an exemplary embodiment of the present disclosure. As shown in Figure 1, the uninterruptible power supply includes: a UPS forestage distribution transformer 101, an uninterruptible power supply module 00, and a battery 104. The uninterruptible power supply module 00 includes: a UPS rectification and discharge multiplexing circuit 102, a battery charging circuit 103, multiple mains relays RLY1 to RLY6, bus capacitors C1 and C2, a charger capacitor C3, charger relays RLY13 and RLY14, multiple mains fuses Fusel to Fuse3, battery fuses Fuse4 and Fuse5, and multiple battery relays RLY7 to RLY12. The rectification and discharge multiplexing circuit 102 includes two rectification and discharge multiplexing units 1021 and 1022.

The UPS forestage distribution transformer 101 includes lines Lu, Lv, Lw, and N. The three-phase electrical output terminals are electrically connected to three mains fuses Fuse1 to Fuse3 respectively. The mains fuses are electrically connected to input terminals of corresponding phases in the two rectifier discharge multiplexing units 1021 and 1022 respectively. Corresponding mains relays are connected in series between the mains fuses and the input terminals. The mains fuse Fuse1 arranged at the U-phase output terminal is electrically connected to the mains relay RLY1 in the rectifier discharge multiplexing circuit 1021 and the mains relay RLY4 in the rectifier discharge multiplexing unit 1022. The mains fuse Fuse2 corresponding to V-phase output terminal is electrically connected to the mains relays RLY2 and RLY5. The mains fuse Fuse3 corresponding to W-phase output terminal is electrically connected to the mains relays RLY3 and RLY6.

The bus capacitor C1 is connected across two output terminals of the rectification and discharge multiplexing unit 1021. The bus capacitor C2 is connected across two output terminals of the rectification and discharge multiplexing unit 1022. A first end of the bus capacitor C1 is connected to a bus BUS+, and a second end of the bus capacitor C1 is connected to a neutral wire N. A first end of the bus capacitor C2 is connected to the neutral wire N, and a second end of the bus capacitor C2 is connected to a bus BUS-.

The bus is electrically connected to two input terminals of the battery charging circuit 103. One output terminal of the battery charging circuit 103 is connected in series with the charger relay RLY13 and the battery fuse Fuse4, and then is connected to a positive electrode of the battery 104. The other output terminal of the battery charging circuit 103 is connected in series with the charger relay RLY14 and the battery fuse Fuse5, and then is connected to a negative electrode of the battery 104.

The battery charging circuit 103 includes multiple transistors which are connected in reverse parallel to freewheeling diodes. An output terminal, electrically connected to the bus BUS-, of the transistors is electrically connected to a positive electrode of a freewheeling diode, and an input terminal, electrically connected to the charger relay RLY14, of the transistors is electrically connected to a negative electrode of the freewheeling diode.

The battery fuse Fuse4 and charger relay RLY13 are electrically connected at a point A. The point A is electrically connected to second ends of the three mains relays in the rectification and discharge multiplexing unit 1021. First ends of the three mains relays are respectively connected to corresponding mains fuses. A battery relay is connected in series between the point A and each of the second ends of the three mains relays. The battery relay RLY7 is connected in series between the point A and the mains relay RLY1, the battery relay RLY8 is connected in series between the point A and the mains relay RLY2, and the battery relay RLY9 is connected in series between the point A and the mains relay RLY3.

The battery fuse Fuse5 and charger relay RLY14 are electrically connected at a point B. The point B is electrically connected to second ends of the three mains relays in the rectification and discharge multiplexing unit 1022. First ends of the three mains relays are respectively connected to corresponding mains fuses. A battery relay is connected in series between the point B and each of the second ends of the three mains relays. The battery relay RLY10 is connected in series between the point B and the mains relay RLY4, the battery relay RLY11 is connected in series between the point B and the mains relay RLY5, and the battery relay RLY12 is connected in series between the point B and the mains relay RLY6.

Based on the circuit connection of the uninterruptible power supply mentioned above, it can be seen that in a case that the uninterruptible power supply operates in a mains mode, the mains relays are closed, and a short-circuit circuit is formed between the battery and the mains electricity if a battery relay connected to the mains relays is short circuited; and in a case that the uninterruptible power supply operates in a battery mode, the battery relays are closed, and a short-circuit circuit is formed between the battery and the mains electricity if a mains relay connected to the battery relays is short circuited. (For example, when the mains relay RLY1 is closed, the battery relay RLY7 is short circuited; or when the battery relay RLY7 is closed, the mains relay RLY1 is short circuited. The short-circuit circuit sequentially includes: the positive electrode battery+ of the battery, the battery fuse Fuse4, the battery relay RLY7, the mains relay RLY1, the mains fuse Fuse1, the U-phase line, the neutral line N, the bus capacitor C2, the freewheeling diode connected in reverse parallel to the transistor Q15, the inductor L8, the charger relay RLY14, the battery fuse Fuse5, and the negative electrode battery- of the battery). The voltage of the short-circuit circuit formed by superimposing a one-phase voltage of the battery and a one-phase voltage of the mains electricity. The superimposed voltage is applied to a bus capacitor, far exceeding a rated value of the bus capacitor, resulting in the failure of the bus capacitor and power failure of the poststage devices of the UPS, and reducing the reliability of the UPS.

To solve the above problem, a fault detection and processing method for an uninterruptible power supply, a fault detection and processing apparatus for an uninterruptible power supply, and a controller are provided according to the present disclosure. According to the technical concept of the present disclosure, the uninterruptible power supply includes at least one uninterruptible power supply module. Each of the at least one uninterruptible power supply module includes: a rectification and discharge multiplexing circuit, a battery, at least one mains switching device and at least one battery switching device. A first end of each of the at least one mains switching device is coupled to a mains input terminal of the uninterruptible power supply. A second end of each of the at least one mains switching device is electrically connected to the rectification and discharge multiplexing circuit and a first end of corresponding at least one battery switching device. A second end of each of the at least one battery switching device is coupled to the battery. The current at at least one sampling point to-be-tested in at least one fault circuit to-be-detected in the uninterruptible power supply is sampled, and the sampled current is compared with a corresponding fault current range to determine the faulty device causing the abnormal current in the fault circuit to-be-detected. Based on the faulty switching device, the operation state of the rectification and discharge multiplexing circuit is adjusted to cut off the fault circuit where the faulty switching device is located, timely stopping the impact of the fault current on the uninterruptible power supply, thereby ensuring the reliability of the power supply system.

Hereinafter, the technical solutions in the present disclosure are described in detail in conjunction with specific embodiments. The following embodiments may be combined with each other, and similar concepts or processes may not be repeated in some embodiments.

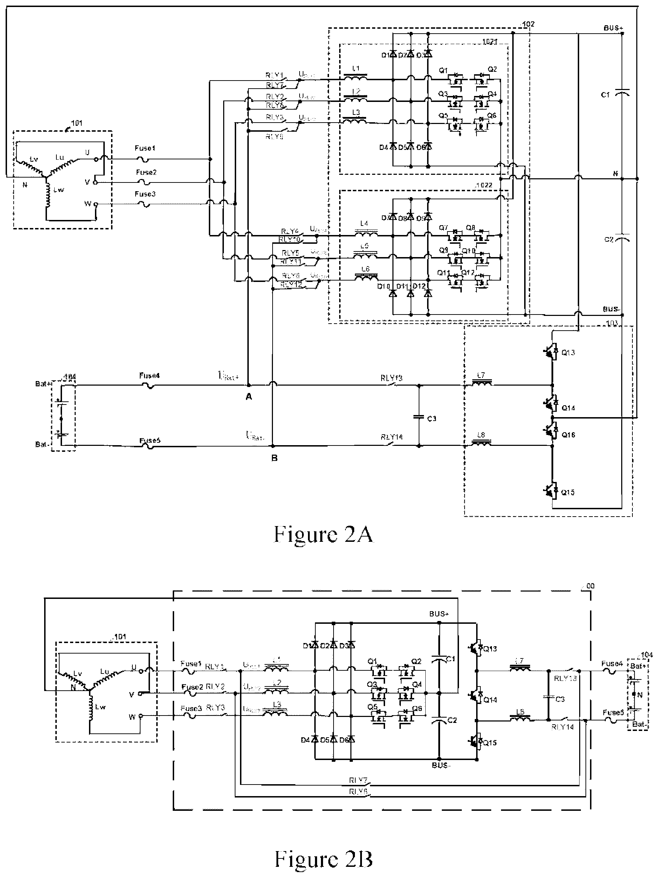

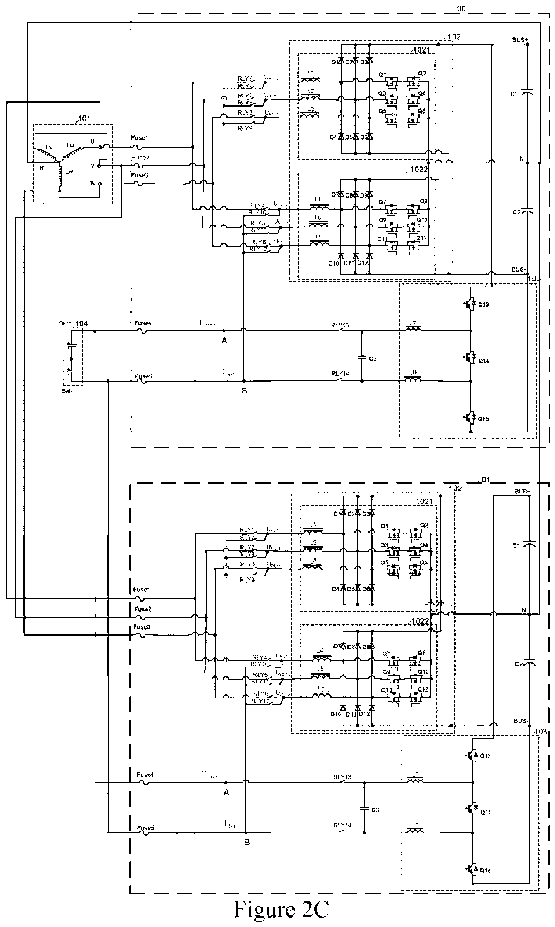

Firstly, the circuit structure of the uninterruptible power supply is explained. The fault detection and processing method for the uninterruptible power supply according to the present disclosure may be applied to an uninterruptible power supply with a rectification and discharge multiplexer converter. In the uninterruptible power supply, a battery switching device is connected in series between a battery and an input terminal of a rectification and discharge multiplexing circuit. In addition to the uninterruptible power supply shown in Figure 1, the uninterruptible power supply may have a variant of the circuit structure shown in Figure 1, including but not limited to the following configurations. An uninterruptible power supply including multiple uninterruptible power supply modules connected in parallel is electrically connected between a UPS forestage distribution transformer 101 and a battery 104 (as shown in Figure 2C). A rectification and discharge multiplexing conversion unit 102 in the uninterruptible power supply only includes one rectification and discharge multiplexing circuit. The Vienna topology in the rectification and discharge multiplexing transformation unit 102 shown in Figure 1 is replaced with an uninterruptible circuit of a BOOST circuit. The battery charging circuit 103 shown in Figure 1 is replaced with a battery charging circuit with a line N (as shown in Figure 2A). The switching devices are replaced with other switching devices such as contactors, SCRs, IGBTs, and MOSFETs. At least one of the battery relays RLY7 to RLY9 is arranged, and at least one of the battery relays RLY10 to RLY 12 is arranged (such as, only RLY7 and RLY10 are arranged).

For the uninterruptible power supply in which the rectification and discharge multiplexing unit 102 only includes one rectification and discharge multiplexing circuit, at least two battery relays are electrically connected between two mains relays, the positive electrode BAT+ of the battery and the negative electrode BAT- of the battery. Figure 2B shows a circuit structure of an uninterruptible power supply. In Figure 2B, a battery relay RLY7 is electrically connected between a second end of a mains relay RLY1 and a positive electrode BAT+ of a battery, and a battery relay RLY8 is electrically connected between a second end of a mains relay RLY2 and a negative electrode BAT- of the battery. When any of the battery relays is short circuited, a short-circuit is formed between the battery and the distribution transformer. The short-circuit circuit is similar to the aforementioned short-circuit circuit, and is not repeated herein.

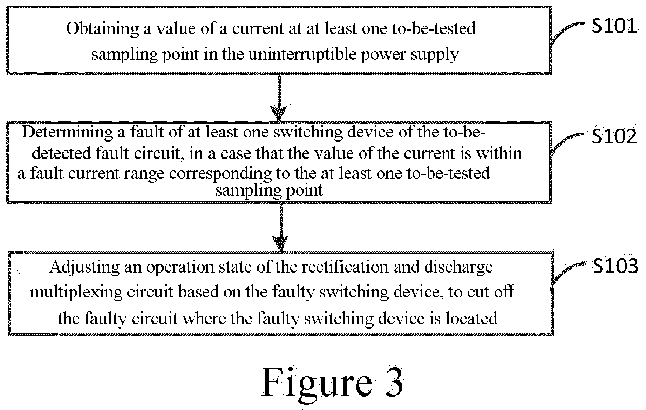

Figure 3 is a flowchart of a fault detection and processing method for an uninterruptible power supply according to an exemplary embodiment of the present disclosure. The method is applied to an uninterruptible power supply including a rectification and discharge multiplexing converter. The method includes the following steps S101 to S103.

In S101, a value of a current at at least one sampling point to-be-tested in the uninterruptible power supply is obtained.

The at least one sampling point to-be-tested is located in at least one fault circuit to-be-detected of the uninterruptible power supply, and each of the at least one fault circuit to-be-detected includes at least one mains switching device and at least one battery switching device.

Each of the at least one fault circuit to-be-detected includes: a mains switching device, a battery switching device connected to the mains switching device, a positive electrode battery+ of a battery, a mains fuse Fuse1, a one-phase current end connected to the mains switching device, a neutral line N, a bus capacitor C2, a freewheeling diode connected in reverse parallel to a transistor Q15, an inductor L8, a charger relay RLY14, a battery fuse Fuse5, and a negative electrode battery- of the battery.

In an embodiment, each of the mains switching device and the battery switching device may be: a relay, a contactor, a SCR, an IGBT, or a MOSFET. The mains switching device and the battery switching device may be other switching devices, which is not limited herein.

The device, for sampling the current at the sampling point, includes but is not limited to: a current transformer, a power resistor, a Hall current sensor, a shunt, and other current detection devices. For the current transformer, the sampling point to-be-tested is placed inside a coil, and then the current at the sampling point is determined based on an induced current. For any one of the other current detection devices, the current detection device may be connected in series to the wire where the detection point is located, and the sampled current may be determined based on a corresponding electrical signal (such as, a value of a voltage) generated by the current detection device.

In S102, it is determined that at least one switching device in the fault circuit to-be-detected is faulty, in a case that the value of the current is within a fault current range corresponding to the at least one to-be-tested sampling point.

In the uninterruptible power supply operating normally without short-circuited switching device, the value of the current at each of sampling points in the fault circuit to-be-detected is within a corresponding normal current range. When a value of a current exceeds the normal current range and is within a fault current range, it is determined that at least one switching device in the fault circuit to-be-detected where the sampling point is located is faulty.

In S103, an operation state of the rectification and discharge multiplexing circuit is adjusted based on the faulty switching device, to cut off the circuit where the faulty switching device is located.

In the circuit structures shown in Figures 1 to 2C, the rectification and discharge multiplexing circuit includes one or more sets of rectification switching devices and rectification bridges. In each of the sets, the rectification switching device includes two switching transistors connected in series, and the rectification switching device is electrically connected, in one-to-one correspondence, to a midpoint of a bridge arm of the corresponding rectification bridge and then is coupled to a second end of a corresponding mains switching device. (For example, in Figure 1, the switching transistors Q1 and Q2 are electrically connected in series, and then are electrically connected to a midpoint of a bridge arm formed by a diode D1 and a diode D4. The midpoint of the bridge arm is electrically connected through an inductor L1 to a second end of a mains switching device RLY1 and a first end of a battery switching device RLY7).

Each of the sets of rectification switching devices corresponds to each of the mains switching devices in one-to-one correspondence. For each of the mains switching devices, a corresponding mains fuse is connected in series between a first end of the mains switching device and a mains input terminal coupled to the mains switching device. (For example, a mains fuse Fuse1 is connected in series between the mains switching device RLY1 and a U-phase mains input terminal coupled to the mains switching device RLY1).

The faulty switching device includes a faulty battery switching device or a faulty mains switching device.

When the mains switching device or the battery switching device fails, at least one set of rectification switching devices corresponding to the mains switching device or the battery switching device are turned on , so that a fuse corresponding to the mains switching device or the battery switching device is cut off. The fuse is a mains fuse or a battery fuse.

Specifically, in a case that the uninterruptible power supply operates in a mains mode and it is determined that the battery switching device is faulty, a set of rectification switching devices corresponding to the battery switching device are turned on to cut off the mains fuse corresponding to the battery switching device; and in a case that the uninterruptible power supply operates in a battery mode and it is determined that the mains switching device is faulty, at least one set of rectification switching devices corresponding to the mains switching device are turned on to cut off the battery fuse. The set of rectification switching devices corresponding to the battery switching device is a set of rectification switching devices corresponding to the mains switching device electrically connected to the battery switching device. The mains fuse corresponding to the battery switching device is the mains fuse that is electrically connected to the mains switching device electrically connected to the battery switching device. The at least one set of rectification switching devices corresponding to the mains switching device include: the battery fuse that is electrically connected to the battery switching device electrically connected to the mains switching device and a battery fuse that is electrically connected to another battery switching device closed simultaneously with the battery switching device in the battery mode.

For example, in a case that the uninterruptible power supply operates in the mains mode, the mains relay RLY1 is closed. If the battery relay RLY7 is short circuited, the short-circuit circuit sequentially includes: the positive electrode battery+ of the battery, the battery fuse Fuse4, the battery relay RLY7, the mains relay RLY1, the mains fuse Fuse1, the U-phase electricity, the median line N, the bus capacitor C2, the freewheeling diode connected in reverse parallel to the transistor Q15, the inductor L8, the charger relay RLY14, the battery fuse Fuse5, and the negative electrode battery- of the battery, which form a fault circuit. After the faulty switching device is determined, the switching transistors Q1 and Q2 coupled to the battery relay RLY7 and the mains relay RLY1 are turned on, so that a fault current flows through the circuit including the neutral line N, the switching transistors Q1 and Q2, the inductor L1, the mains relay RLY1, the mains fuse Fuse1, and the U-phase electricity. The high current flowing in the circuit cuts off the fuse Fuse1, so that the fault circuit is cut off.

For another example, in a case that the uninterruptible power supply operates in the battery mode, the battery relays RLY7 and RLY10 are closed. If the mains relay RLY1 is short circuited, a short-circuit circuit same as above is formed. After the faulty switching device is determined, the switching transistors Q1 and Q2 coupled to the battery relay RLY7 are turned on, and the switching transistors Q7 and Q8 coupled to the battery relay RLY10 are turned on, so that a fault current flows through the circuit including the positive electrode battery+ of the battery, the battery fuse Fuse4, the battery relay RLY7, the inductor L1, the switching transistors Q1, Q2, Q7 and Q8, the inductor L4, the battery relay RLY10, the battery fuse Fuse5, and the negative electrode battery- of the battery. The high current flowing in the circuit cuts off the battery fuse Fuse4 and/or the battery fuse Fuse5, so that the fault circuit is cut off.

In the above technical solutions, the current at at least one sampling point to-be-tested in at least one fault circuit to-be-detected in the uninterruptible power supply is sampled, and the sampled current is compared with a corresponding fault current range to determine the faulty device causing the abnormal current in the fault circuit to-be-detected. The operation state of the rectification and discharge multiplexing circuit is adjusted based on the faulty switching device, to cut off the fault circuit where the faulty switching device is located, timely stopping the impact of the fault current on the uninterruptible power supply, thereby ensuring the reliability of the power supply system.

For different positions where the sampling point to-be-tested is arranged, the conditions for determining a faulty switching device are different. Taking the circuit structure shown in Figure 1 as an example, for the different positions of the sampling point to-be-tested and the corresponding determination conditions, the fault detection and processing method according to the present disclosure is illustrated with reference to multiple embodiments.

In an embodiment, the sampling point is arranged at a first end of a mains switching device to-be-tested, then it is determined whether a mains switching device or a battery relay is faulty based on a current at the mains switching device.

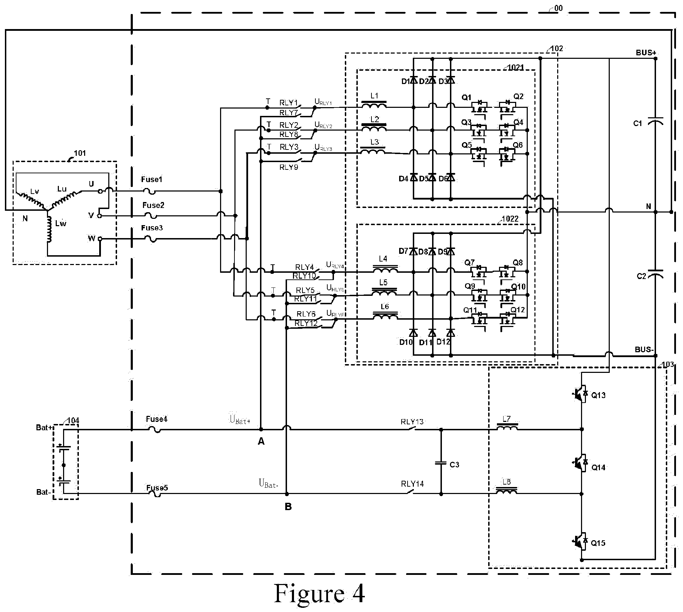

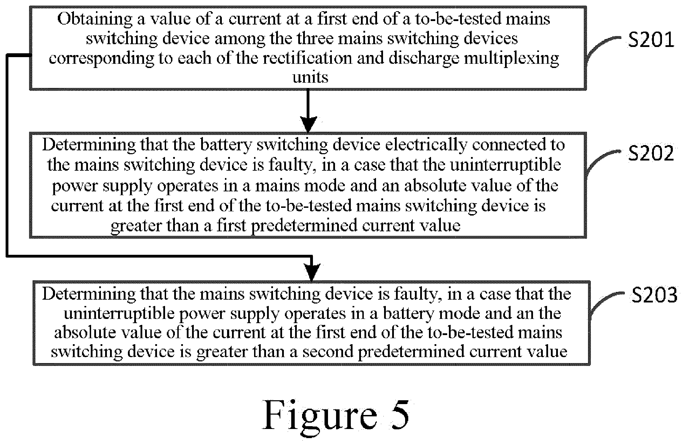

In a case, sampling point are arranged at points T as shown in Figure 4, the fault detection and processing method includes the following steps S201 to S203 as shown in Figure 5.

In S201, for each of the rectification and discharge multiplexing units, a value of a current at a first end of a mains switching device to-be-tested among three mains switching devices corresponding to the rectification and discharge multiplexing unit is obtained.

That is, a value of a current at a mains switching device electrically connected to the rectification and discharge multiplexing units 1021 and 1022 is obtained.

In a case that the uninterruptible power supply operates in the mains mode, proceed to step S202; and in a case that the uninterruptible power supply operates in the battery mode, proceed to step S203.

In S202, in a case that the uninterruptible power supply operates in the mains mode and an absolute value of the value of the current at the first end of the mains switching device to-be-tested is greater than a first predetermined current value, it is determined that the battery switching device electrically connected to the mains switching device is faulty.

In the mains mode, the mains switching device is closed and the battery switching device is turned off, the value of the current at the mains switching device does not exceed a maximum input current of the rectification and discharge multiplexing units 1021 and 1022. The maximum input current is determined as a first predetermined current value. In a case that the value of the current at the mains switching device is greater than the first predetermined current value, it is determined that a fault current due to that the battery switching device is short circuited exists. Thus, the controller turns on the rectification switching device coupled to the faulty mains switching device (for example, when the battery switching device RLY8 is short circuited, the switching transistors Q1 and Q2 are turned on), and the mains fuse electrically connected to the faulty mains switching device is cut off, so that the fault circuit where the mains switching device is arranged is cut off.

In S203, in a case that the uninterruptible power supply operates in the battery mode and the absolute value of the value of the current at the first end of the mains switching device to-be-tested is greater than a second predetermined current value, it is determined that the mains switching device is faulty.

In the battery mode, the mains switching device is turned off and the battery switching device is closed. The value of the current at the mains switching device is 0, and is determined as a second predetermined current value. In a case that the value of the current at the mains switching device is greater than the second predetermined current value, it is determined that a fault current due to a short circuit of the mains switching device. Thus, the controller turns on the rectification switching device coupled to the faulty battery switching device and rectification switching devices coupled to other battery switching devices that are turned on simultaneously with the faulty battery switching device, and at least one battery fuse is cut off, so that the fault circuit where the battery switching device is arranged is cut off. For example, when the mains switching device RLY1 fails, in the battery mode, if the battery switching devices RLY7 and RLY10 are same-phase switching devices and are both closed, the switching transistors Q1, Q2, Q7 and Q8 are turned on.

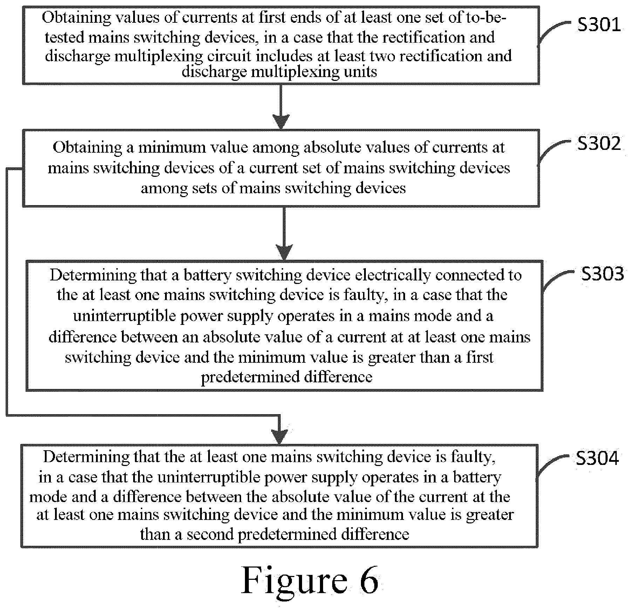

In another case, based on the sampling points shown in Figure 4, the fault detection and processing method includes the following steps S301 to S304 as shown in Figure 6.

In S301, in a case that the rectification and discharge multiplexing circuit includes at least two rectification and discharge multiplexing units, values of currents at first ends of at least one set of mains switching devices to-be-tested are obtained.

One set of mains switching devices to-be-tested includes main switching devices coupled to a same phase mains terminal, such as RLY1 and RLY4, RLY2 and RLY5, and RLY3 and RLY6.

Two mains switching devices of one set are respectively arranged in two fault circuits to-be-detected.

In S302, for each set of mains switching devices, a minimum value of absolute values of values of currents at mains switching devices in the set of mains switching devices is obtained.

Absolute values of values of sampled currents at two mains switching devices of one set of mains switching devices are compared to determine the minimum value.

Normally, the values of the currents of the two mains switching devices are the same. In a case that a fault current exists, the absolute value of the value of the current at the mains switching device in the fault circuit is greater than the absolute value of the value of the current at the other mains switching device.

In a case that the uninterruptible power supply operates in the mains mode, proceed to step S303; and in a case that the uninterruptible power supply operates in the battery mode, proceed to step S304.

In S303, in a case that the uninterruptible power supply operates in the mains mode and a difference between an absolute value of a value of a current at at least one mains switching device and the minimum value is greater than a first predetermined difference, it is determined that a battery switching device electrically connected to the at least one mains switching device is faulty.

In S304, in a case that the uninterruptible power supply operates in the battery mode and the difference between an absolute value of a value of a current at at least one mains switching device and the minimum value is greater than a second predetermined difference, it is determined that the at least one mains switching device is faulty.

In the embodiment, the currents of mains switching devices in the same phase or the currents of battery switching devices in the same phase are compared. In a case that the uninterruptible power supply operates normally, the absolute values of the values of the currents at the switching devices in the same phase are identical. When a fault current flows through a switching device, the absolute value of the value of the current of the switching device increases due to the fault current, and the value of the current of the switching device is greater than the value of the current at the switching device in the same phase in the normal circuit. In comparing the currents, the value of the current at the switching device that is not in the fault circuit is determined as the minimum value. The difference between the value of the current at the switching device in the fault circuit and the minimum value is greater than the first predetermined difference in the mains mode and is greater than the second predetermined difference in the battery mode.

Considering fluctuation of current values, the first predetermined difference and the second predetermined difference are greater than a maximum fluctuation current difference and less than a difference between the fault current and a normal operation current.

After having determined the faulty switching device, the controller turns on the rectification switching device coupled to the faulty switching device. In the mains mode, the mains fuse in the fault circuit is cut off. In the battery mode, the battery fuse in the fault circuit is cut off to cut off the fault circuit where the faulty switching device is located.

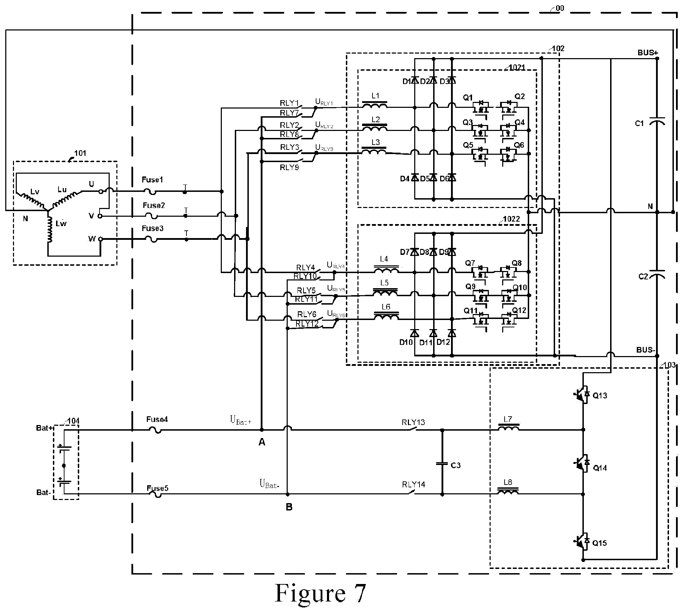

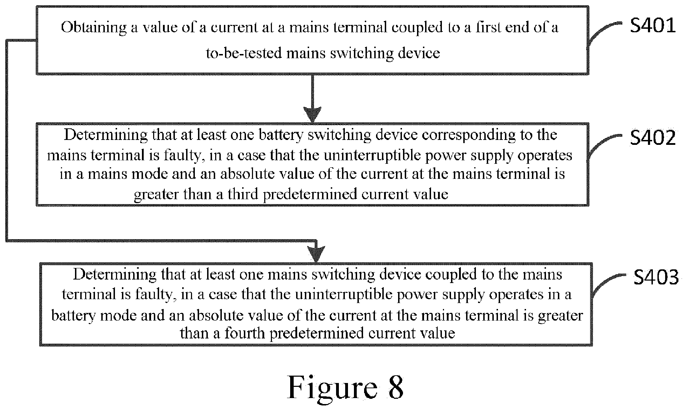

In another case, the positions of the sampling points are configured as shown in Figure 7, the corresponding fault detection and processing method includes the following steps S401 to S403 as shown in Figure 8.

In S401, a value of a current at a mains terminal coupled to the first end of the mains switching device to-be-tested is obtained.

The sampling point is arranged on a phase line. The sampling point arranged on a U-phase line is used for detecting the fault situation of the fault circuit to-be-detected where the mains switching devices RLY1 and RLY4 are located. The sampling point arranged on a V-phase line is used for detecting the fault situation of the fault circuit to-be-detected where the mains switching devices RLY2 and RLY5 are located. The sampling point arranged on a W-phase line is used for detecting the fault situation of the fault circuit to-be-detected where the mains switching devices RLY3 and RLY6 are located.

In a case that the uninterruptible power supply operates in the mains mode, proceed to step S402; and in a case that the uninterruptible power supply operates in the battery mode, proceed to step S403.

In S402, in a case that the uninterruptible power supply operates in the mains mode and an absolute value of the value of the current at the mains terminal is greater than a third predetermined current value, it is determined that at least one battery switching device corresponding to the mains terminal is faulty.

The battery switching device corresponding to the mains terminal is electrically connected to the mains switching device coupled to the mains terminal.

In an embodiment, the third predetermined current value is equal to an absolute value of a maximum value of a current flowing through a phase line in the normal operation of the uninterruptible power supply.

In a case that the absolute value of the value of the current at the U-phase line is greater than the third predetermined current, it is determined that the battery switching devices RLY7 and/or RLY10 are faulty. The fault determination conditions for other phase lines are similar, and are not repeated herein.

In S403, in a case that the uninterruptible power supply operates in the battery mode and an absolute value of the value of the current at the mains terminal is greater than a fourth predetermined current value, it is determined that at least one mains switching device coupled to the mains terminal is faulty.

In the uninterruptible power supply operating in the battery mode, the mains switching device is not closed, and the value of the current at the mains switching device is equal to 0. In an embodiment, the fourth predetermined current value is set to 0.

In a case that the absolute value of the value of the current at the U-phase line is greater than the third predetermined current, it is determined that the mains switching devices RLY1 and/or RLY4 are faulty. The fault determination conditions for other phase lines are similar, and are not repeated herein.

In the mains mode, the controller turns on all the rectification switching devices coupled to the mains switching devices coupled to the mains terminal in the phase, to cut off the mains fuse connected to the mains terminal in the phase, so that the fault circuit is cut off. For example, in a case that it is determined that the fault current flows through the U-phase line, in the circuit structure shown in Figure 7, the switching transistors Q1 and Q2 coupled to the mains switching device RLY1 and the switching transistors Q7 and Q8 coupled to the mains transistors device RLY4 are turned on, so that the mains fuse Fuse1 is cut off.

In the battery mode, the controller turns on all the rectification switching devices connected to the battery switching devices connected to the mains switching devices coupled to the mains terminal in the phase, to cut off the battery fuse, so that the fault circuit is cut off. For example, in a case that it is determined that the fault current flows through the U-phase line, in the circuit structure shown in Figure 7, the battery switching devices electrically connected to the mains switching devices RLY1 and RLY4 and the switching transistors Q1, Q2, Q7 and Q8 coupled to the mains switching device RLY7 and RLY10 are turned on, so that the battery fuses Fuse4 and Fuse5 are cut off.

In another embodiment, the sampling points are configured at the second ends of the battery switching devices to-be-tested, and it is determined whether a mains switching device or a battery relay is faulty based on the value of the current at the battery switching devices.

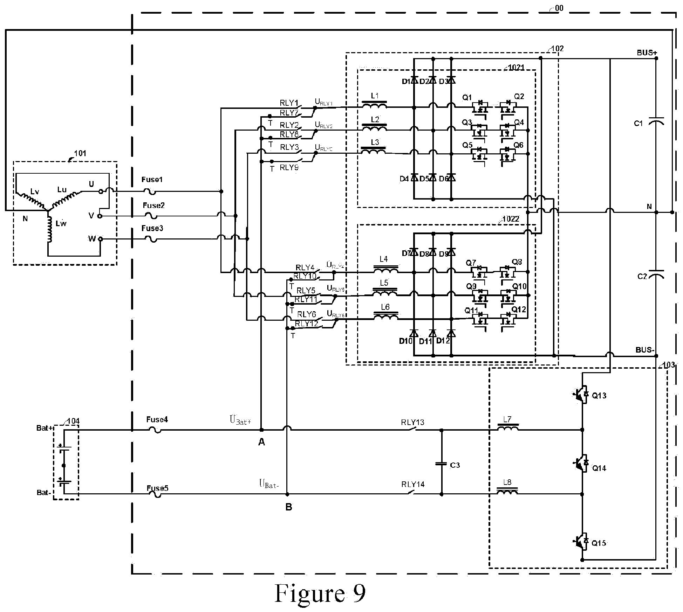

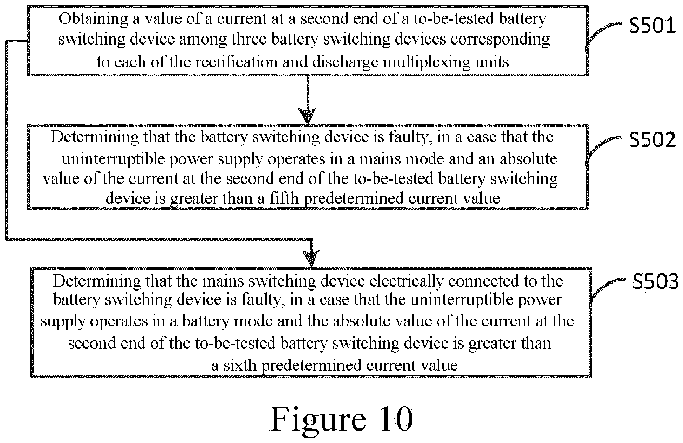

In another case, the positions of the sampling points are configured as shown in Figure 9, the fault detection and processing method includes the following steps S501 to S503 as shown in Figure 10.

In S501, for the at least one rectification and discharge multiplexing unit, a value of a current at a second end of a battery switching device to-be-tested among the three battery switching devices corresponding to the rectification and discharge multiplexing unit is obtained.

In a case that the uninterruptible power supply operates in the mains mode, proceed to step S502; and in a case that the uninterruptible power supply operates in the battery mode, proceed to step S503.

In S502, in a case that the uninterruptible power supply operates in the mains mode and an absolute value of the value of the current at the second end of the battery switching device to-be-tested is greater than a fifth predetermined current value, it is determined that the battery switching device is faulty.

In the uninterruptible power supply operating in the mains mode, the battery switching device is not closed, and the value of the current at the battery switching device is equal to 0. In an embodiment, the fifth predetermined current value is set to 0.

In S503, in a case that the uninterruptible power supply operates in the battery mode and an absolute value of the value of the current at the second end of the battery switching device to-be-tested is greater than a sixth predetermined current value, it is determined that the mains switching device electrically connected to the battery switching device is faulty is faulty.

In an embodiment, the sixth predetermined current value is equal to an absolute value of a maximum value of currents flowing through the battery switching devices in the normal operation of the uninterruptible power supply.

According to the present disclosure, the current at the battery relays is sampled. In the mains mode, the battery switching device is turned off, and no current is detected. When it is detected that the absolute value of the value of the current is greater than the fifth predetermined current, it is determined that the battery switching device is short circuited. The controller turns on the switching transistor coupled to the mains switching device electrically connected to the battery switching device, so that the mains fuse electrically connected to the mains switching device is cut off, and the fault circuit where the switching device is located is cut off. In the battery mode, the battery switching device is turned on, the absolute value of the value of the current is less than or equal to the sixth predetermined current value. When the mains switching device connected to the battery switching device is short circuited, the absolute value of the value of the current at the battery switching device increases, then it is determined that the mains switching device is faulty. The controller turns on the switching transistor coupled to the battery switching device and the switching transistor coupled to other battery switching device in the same phase, so that the battery fuse is cut off, and the fault circuit where the switching device is located is cut off.

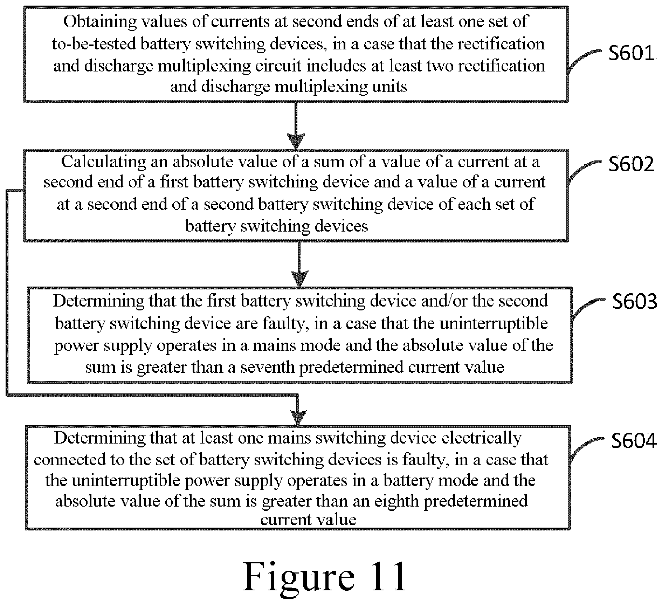

In another case, based on the sampling points shown in Figure 9, the fault detection and processing method includes the following steps S601 to S604 as shown in Figure 11.

In S601, in a case that the rectification and discharge multiplexing circuit includes at least two rectification and discharge multiplexing units, values of currents at second ends of at least one set of battery switching devices to-be-tested are obtained.

A set of battery switching devices includes two battery switching devices both of which closed in the battery mode to form a battery power supply circuit. That is, one battery switching device electrically connected to the positive electrode of the battery and one battery switching device electrically connected to the negative electrode of the battery.

In S602, for each set of battery switching devices, an absolute value of a sum of a value of a current at a second end of the first battery switching device and a value of a current at a second end of the second battery switching device in the set of battery switching devices are calculated.

In a case that the uninterruptible power supply operates in the mains mode, proceed to step S603; and in a case that the uninterruptible power supply operates in the battery mode, proceed to step S604.

In S603, in a case that the uninterruptible power supply operates in the mains mode and the absolute value of the sum is greater than a seventh predetermined current value, it is determined that the first battery switching device and/or the second battery switching device are faulty.

In S604, in a case that the uninterruptible power supply operates in the battery mode and the absolute value of the sum is greater than an eighth predetermined current value, it is determined that at least one mains switching device electrically connected to the set of battery switching devices is faulty.

In the present disclosure, in the battery mode, the currents of a set of battery switching devices are equal in magnitude and opposite in direction, and accordingly the sum of the values of the detected currents is equal to 0. When a mains switching device electrically connected to a battery switching device is short circuited, the sum of the values of the currents of the battery switching device is not equal to 0, so that it is determined that the battery switching device is faulty. In an embodiment, the seventh predetermined current value is set to 0.

In the mains mode, the battery switching device is turned off, and the sum of the sampled currents is 0. When the value of the sampled current is not 0, it is determined that the battery switching device is faulty. In an embodiment, the eighth predetermined current value is determined to be 0.

After the set of switching devices including a faulty switching device are determined, in the mains mode, the controller turns on the rectification switching device coupled to the set of mains switching devices, and the mains fuse corresponding to the switching device is cut off; in the battery mode, the controller turns on the rectification switching device coupled to the set of the battery switching devices, and the battery fuse is cut off. Thus, the fault circuit where the switching device is located is cut off.

In another embodiment, the sampling point is disposed on a wire between the battery switching device and the battery, and it is determined whether a mains switching device or a battery relay electrically connected to the wire is faulty, based on the value of the current at the wire.

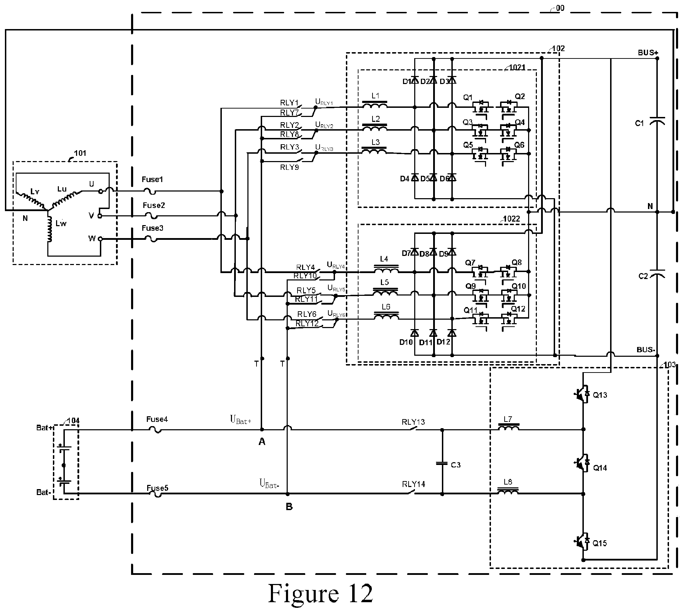

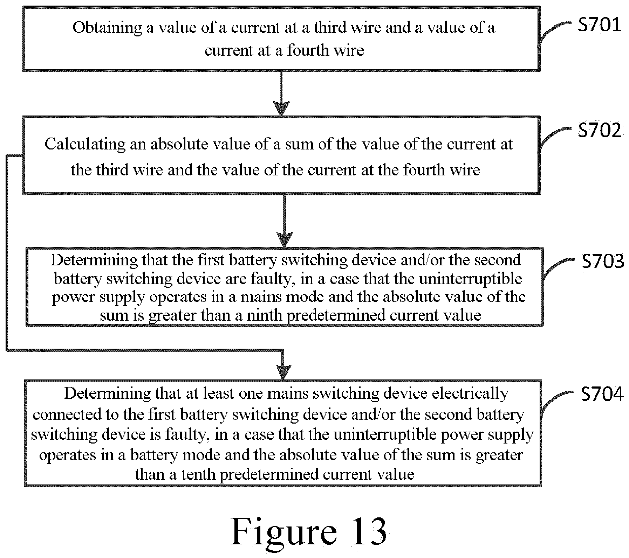

In a scenario, the positions of the sampling points are configured as shown in Figure 12, the fault detection and processing method includes the following steps S701 to S704 as shown in Figure 13.

In S701, a value of a current at a third wire and a value of a current at a fourth wire are obtained.

The third wire and the fourth wire are wires between a point electrically connected to the second ends of the battery switching devices and point A or point B. In one scenario, as shown in Figure 12, a longitudinal wire on the left side of the sampling point T is the third wire, and a longitudinal wire on the right side of the sampling point T is the fourth wire.

In S702, an absolute value of a sum of the value of the current at the third wire and the value of the current at the fourth wire is calculated.

In a case that the uninterruptible power supply operates in the mains mode, proceed to step S703; and in a case that the uninterruptible power supply operates in the battery mode, proceed to step S704.

In S703, in a case that the uninterruptible power supply operates in the mains mode and the absolute value of the sum is greater than a ninth predetermined current value, it is determined that the first battery switching device and/or the second battery switching device are faulty.

In S704, in a case that the uninterruptible power supply operates in a battery mode and the absolute value of the sum is greater than a tenth predetermined current value, it is determined that at least one mains switching device electrically connected to the first battery switching device and/or the second battery switching device is faulty.

Similar to the embodiments shown in steps S601 to S604, in the mains mode, no current flows through the third wire and the fourth wire, and the sum of currents is 0. When a non-zero current value is detected, it is determined that at least one of the six battery switching devices is faulty. In an embodiment, the ninth predetermined current value is set to 0. In the battery mode, the currents at the third wire and the fourth wire are equal in magnitude and opposite in direction. When a non-zero current value is detected, it is determined that at least one of the six mains switching devices is faulty. In another embodiment, the tenth predetermined current value is set to 0.

In the embodiment, when it is determined that the absolute value of the sum of the value of the current at the third wire and the value of the current at the fourth wire is greater than the ninth predetermined current value or the tenth predetermined current value, the rectification switching devices corresponding to all of the battery switching devices electrically connected to the third wire and the fourth wire are controlled to be turned on, so that the mains fuse corresponding to the faulty switching device is cut off in the mains mode, or the battery fuse is cut off in the battery mode.

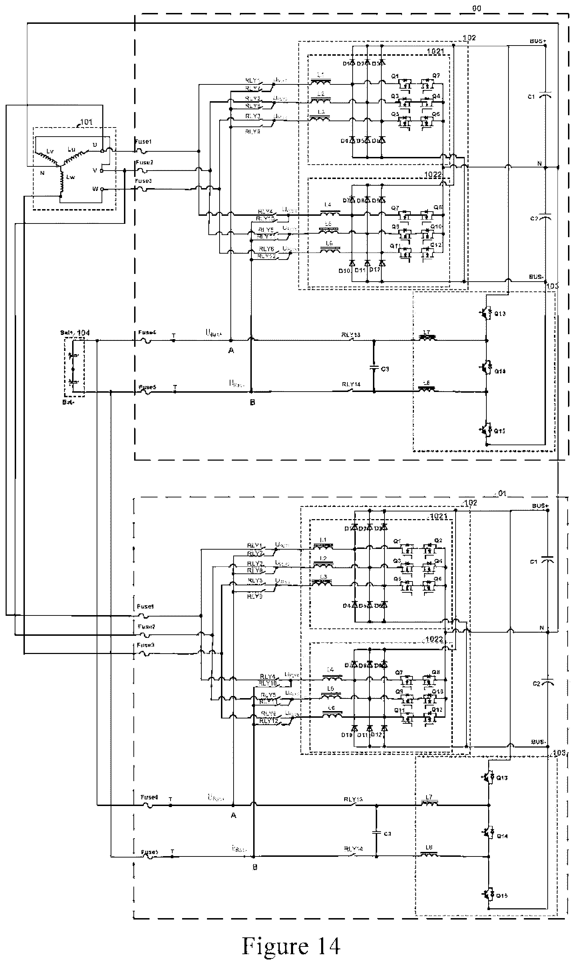

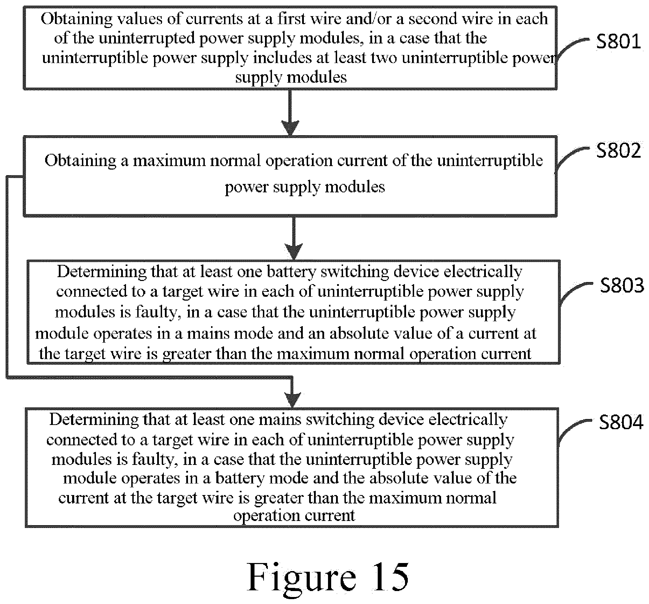

In another case, the positions of the sampling points are configured as shown in Figure 14, the fault detection and processing method includes the following steps S801 to S804 as shown in Figure 15.

In S801, in a case that the uninterruptible power supply includes at least two uninterruptible power supply modules, a value of a current at a first wire and/or a second wire in each of the uninterrupted power supply modules is obtained.

In S802, a maximum normal operation current of the uninterruptible power supply modules is obtained.

In a case that the uninterruptible power supply operates in the mains mode, proceed to step S803; and in a case that the uninterruptible power supply operates in the battery mode, proceed to step S804.

In S803, for each of the uninterruptible power supply modules, in a case that the uninterruptible power supply module operates in a mains mode and an absolute value of a value of a current at a target wire is greater than the maximum normal operation current, it is determined that at least one battery switching device electrically connected to the target wire is faulty.

In S804, for each of the uninterruptible power supply modules, in a case that the uninterruptible power supply module operates in a battery mode and an absolute value of a value of a current at a target wire is greater than the maximum normal operation current, it is determined that at least one mains switching device electrically connected to the target wire is faulty.

In the present disclosure, the detection points are disposed on the first wire between point A and the positive electrode battery+ of the battery and on the second wire between point B and the negative electrode battery- of the battery in each uninterrupted power supply module. In a case that there is no fault circuit, the currents at the two points in the uninterruptible power supply module are equal in magnitude and opposite in direction, and the absolute values of the values of the currents at the two points are both less than the maximum normal operation current.

In a case that there is a fault circuit, the currents at the same type of wires in other uninterruptible power supply modules flows through the wire of the faulty uninterruptible power supply module, resulting in an increase in the absolute value of the value of the current at the wire.

For example, in a case that at least one (such as RLY1) of the mains switching devices RLY1 to RLY3 in the uninterruptible power supply module 00 fails and the uninterruptible power supply operates in the battery mode, a fault circuit is formed which including: the positive electrode battery+ of the battery, the battery relay RLY7 in the uninterruptible power supply module 00, the mains relay RLY1 in the uninterruptible power supply module 00, the mains fuse Fuse1 in the uninterruptible power supply module 00, the U-phase line, the neutral line N, the bus capacitor C2 in the uninterruptible power supply module 00 and the uninterruptible power supply module 01, the freewheeling diode connected in reverse parallel with the transistor Q15 in the uninterruptible power supply module 00 and the uninterruptible power supply module 01, the inductor L8 in the uninterruptible power supply module 00 and the uninterruptible power supply module 01, the charger relay RLY14 in the uninterruptible power supply module 00 and the uninterruptible power supply module 01, the battery fuse Fuse5 in the uninterruptible power supply module 00 and the uninterruptible power supply module 01, and the negative electrode battery- of the battery. In normal operation, the value of the current on the first wire of each of the uninterruptible power supply modules is +XA, and the value of the current on the second wire of each of the uninterruptible power supply modules is -XA, where X represents a current value. In a case that a faulty switching device exists in the uninterruptible power supply module 00, the value of the current value at the first wire of the uninterruptible power supply module 00 is +2XA, and the value of the current value at the second wire of the uninterruptible power supply module 00 is -XA. The value of the current value at the first wire of the uninterruptible power supply module 01 is 0A, and the value of the current value at the second wire of the uninterruptible power supply module 01 is -XA. The maximum normal operation current is set to a value ranging from XA to 2XA. Based on the maximum normal operation current, it is determined that the switching device connected to the first wire in the uninterruptible power supply module 00 is faulty.

In the present embodiment, when it is determined that the absolute value of the current on the first wire or the second wire is greater than the maximum normal operation current, the rectification switching devices corresponding to all of the battery switching devices electrically connected to the wire are controlled to be turned on, so that the mains fuse corresponding to the faulty switching device is cut off in the mains mode or the battery fuse is cut off in the battery mode.

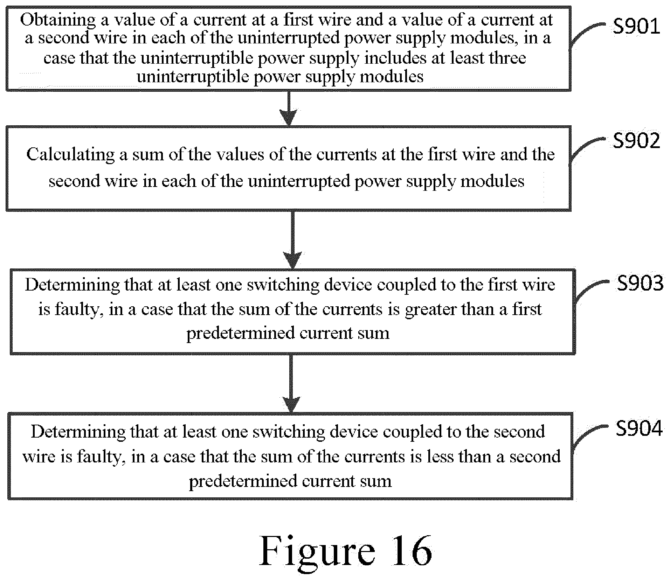

Referring to Figure 14, the fault detection and processing methods includes the following steps S901 to S904 as shown in Figure 16.

In S901, in a case that the uninterruptible power supply includes at least three uninterruptible power supply modules, a value of a current at a first wire and a value of a current at a second wire in each of the uninterrupted power supply modules are obtained.

In S902, a sum of the values of the currents at the first wire and the second wire in each of the uninterrupted power supply modules is calculated.

In S903, in a case that the sum of the currents is greater than a first predetermined current sum, it is determined that at least one switching device coupled to the first wire is faulty.

In the case that the sum of the currents is greater than the first predetermined current sum, it is determined that a switching device is faulty by: if the uninterruptible power supply operates in the mains mode, determining that at least one battery switching device connected to the first wire is faulty; and if the uninterruptible power supply operates in the battery mode, determining that at least one mains switching device connected to the first wire is faulty.

In S904, in a case that the sum of the currents is less than a second predetermined current sum, it is determined that at least one switching device coupled to the second wire is faulty.

In the case that the sum of the currents is less than the second predetermined current sum, it is determined that at least one switching device is faulty by: if the uninterruptible power supply operates in the mains mode, determining that at least one battery switching device connected to the second wire is faulty; and if the uninterruptible power supply operates in the battery mode, determining that at least one mains switching device connected to the second wire is faulty.

In the embodiment, in a case that the uninterruptible power supply module fails, the fault circuit is similar to the fault circuit described in the embodiment shown in Figure 15. A current with a value equal to the sum of the values of the currents at the same type of wires in all uninterruptible power supply modules flows through the wire connected to the faulty switching device, and the current at another type of wire remains unchanged. Taking an uninterruptible power supply including three uninterruptible power supply modules as an example, the fault detection and processing method according to the embodiment is described. The three uninterruptible power supply modules include: an uninterruptible power supply module 00, an uninterruptible power supply module 01, and an uninterruptible power supply module 02.

It is defined that the current on the first wire electrically connected to the positive electrode of the battery is a forward current, and the current on the second wire electrically connected to the negative electrode of the battery is a reverse current. In normal operation, in each uninterruptible power supply module, the value of the current on the first wire is +XA, and the value of the current on the second wire is -XA, where X represents a current value. In a case that the battery relay RLY7 in the uninterruptible power supply module 00 fails, in the operation of the uninterruptible power supply, the value of the current on the first wire in the uninterruptible power supply module 00 is +3XA, and the values of the currents at the first wires in the uninterruptible power supply modules 01 and 02 are 0A. The values of the currents at the second wires of the three uninterruptible power supply modules are all -XA. For the uninterruptible power supply module 00, the sum of the value of the current on the first wire and the value of the current on the second wire is +2XA. For each of the uninterruptible power supply module 01 and the uninterruptible power supply module 02, the sum of the value of the current on the first wire and the value of the current on the second wire is -XA. It is configured that the first predetermined current value is greater than +XA and less than +2XA, then it is determined that at least one switching device coupled to the first wire in the uninterruptible power supply module 00 is faulty. It is necessary to turn on the rectification switching devices corresponding to all the switching devices coupled to the faulty switching device, so that the fuse corresponding to the faulty switching device is cut off. The situation of the cut off fuse is similar to the situation described in the embodiment shown in Figure 15, and is not repeated herein.

Similarly, in a case that at least one mains switching device or one battery switching device coupled to the second wire in uninterruptible power supply module 00 fails, the value of the current on the second wire in uninterruptible power supply module 00 is -3XA, the value of the current on the first wire is +XA, and the value of the current on the second wire in other uninterruptible power supply module is 0A. The value of the current on the first wire is +XA. For the uninterruptible power supply module 00, the sum of the value of the current on the first wire and the value of the current on the second wire is -2XA. For each of the uninterruptible power supply module 01 and the uninterruptible power supply module 02, the sum of the value of the current on the first wire and the value of the current on the second wire is +XA. It is configured that the second predetermined current value is greater than -2XA and less than -XA, then it is determined that at least one switching device coupled to the second wire in the uninterruptible power supply module 00 is faulty. It is necessary to turn on the rectification switching devices corresponding to all of the switching devices coupled to the faulty switching device, so that the fuse corresponding to the faulty switching device is cut off. The situation of the cut off fuse is similar to the situation described in the embodiment shown in Figure 15, and is not repeated herein.

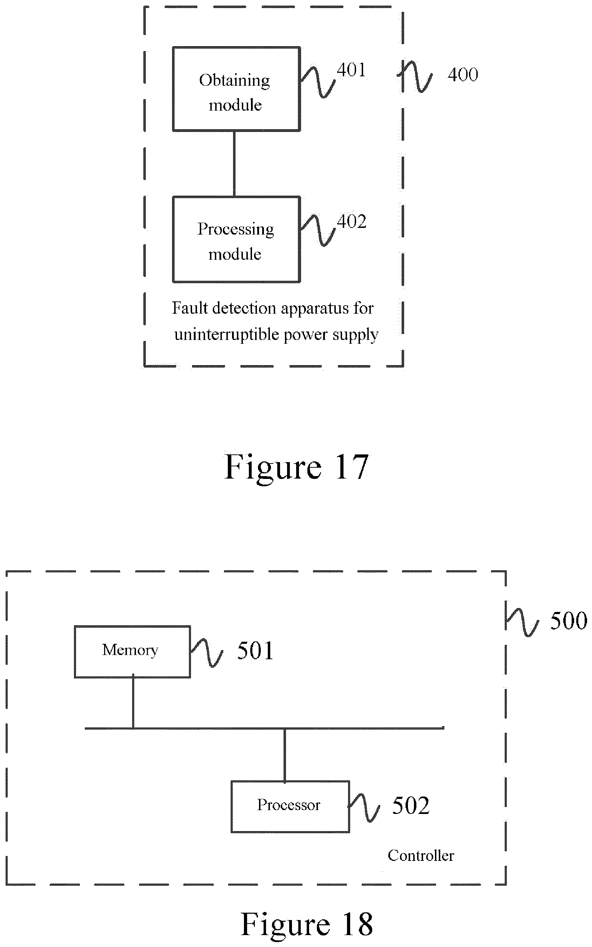

Figure 17 is a schematic structural diagram of a fault detection and processing apparatus for an uninterruptible power supply according to an exemplary embodiment of the present disclosure. The fault detection and processing apparatus 400 for an uninterruptible power supply includes: an obtaining module 401 and a processing module 402.

The obtaining module 401 is configured to obtain a value of a current at at least one sampling point to-be-tested in the uninterruptible power supply. The at least one sampling point to-be-tested is located in at least one fault circuit to-be-detected of the uninterruptible power supply, and each of the fault circuit to-be-detected includes at least one mains switching device and at least one battery switching device.

The processing module 402 is configured to determine that at least one switching device in the fault circuit to-be-detected is faulty, in a case that the value of the current is within a fault current range corresponding to the at least one to-be-tested sampling point.

The processing module 402 is further configured to adjust an operation state of the rectification and discharge multiplexing circuit based on the faulty switching device, to cut off the circuit where the faulty switching device is located.

Figure 18 is a schematic structural diagram of a controller according to an embodiment of the present disclosure. The controller 500 includes: a memory 501 and a processor 502. The memory 501 is used to store computer instructions that may be executed by the processor. The memory 501 may include a high-speed random access memory (RAM), a non-volatile memory (NVM) such as at least one disk storage, and may include a USB drive, a removable hard drive, a read-only memory, a disk, or an optical disc.

The processor 502, when executing computer instructions, performs the steps of the fault detection and processing method for an uninterruptible power supply with the controller as the execution body in the above embodiments. For details, please refer to the relevant description in the aforementioned method embodiments. The processor 502 may be a central processing unit (CPU), a general-purpose processor, a digital signal processor (DSP), an application specific integrated circuit (ASIC), and the like. The general-purpose processor may be a microprocessor or any conventional processor. The steps of the method according to the present disclosure may be directly performed by a hardware processor, or may be performed by a combination of hardware and software modules in a processor.

Optionally, the memory 501 may be independent or integrated with the processor 502. When the memory 501 is independently configured, the controller 500 further includes a bus for connecting the memory 501 and the processor 502. The bus may be an Industry Standard Architecture (ISA) bus, an External Component Interconnect (PCI) bus, an Extended Industry Standard Architecture (EISA) bus, or the like. The bus may include an address bus, a data bus, a control bus, and the like. For ease of description, the bus in the accompanying drawings in the present disclosure is not limited to only one bus or one type of bus.

According to the present disclosure, a computer-readable storage medium is further provided. The computer-readable storage medium stores computer instructions. The computer instructions, when executed by a processor, cause the processor to perform the steps of the fault detection and processing method for an uninterruptible power supply described in the above embodiments.

According to the present disclosure, a computer program product is further provided. The computer program product includes computer instructions. The computer instructions, when executed by a processor, cause the processor to perform the steps of the fault detection and processing method for an uninterruptible power supply described in the above embodiments.

Those skilled in the art may easily obtain other embodiments of the present disclosure after considering the specification and practicing the solutions disclosed herein. The present disclosure includes all variations, usages, or adaptive modifications of the present disclosure. These variations, usages, or adaptive modifications follow the general principles of the present disclosure and include common knowledge or customary technical means in the technical field not disclosed in the present disclosure. The specification and embodiments are only exemplary, and the scope and spirit of present disclosure are determined by the following claims.

It should be understood that the present disclosure is not limited to the precise structure described above and shown in the drawings, and various modifications and variations may be made without departing from the scope of the present disclosure. The scope of t the present disclosure is limited only by the claims.

## Claims

1. A fault detection and processing method for an uninterruptible power supply, wherein the uninterruptible power supply comprises at least one uninterruptible power supply module, each of the at least one uninterruptible power supply module comprises a rectification and discharge multiplexing circuit, a battery, at least one mains switching device and at least one battery switching device, a first end of each of the at least one mains switching device is coupled to a mains input terminal of the uninterruptible power supply, a second end of each of the at least one mains switching device is electrically connected to the rectification and discharge multiplexing circuit and a first end of a corresponding one of the at least one battery switching device, and a second end of the corresponding one of the at least one battery switching device is coupled to the battery;
the method comprises:
obtaining a value of a current at at least one sampling point to-be-tested in the uninterruptible power supply, wherein the at least one sampling point to-be-tested is located in at least one fault circuit to-be-detected of the uninterruptible power supply, and each of the at least one fault circuit to-be-detected comprises at least one mains switching device and at least one battery switching device;
determining that at least one switching device in the fault circuit to-be-detected is faulty in a case that the value of the current is within a fault current range corresponding to the at least one sampling point to-be-tested; and
adjusting an operation state of the rectification and discharge multiplexing circuit based on the faulty switching device to cut off the fault circuit where the faulty switching device is located.

2. The method according to claim 1, wherein
the rectification and discharge multiplexing circuit comprises at least one set of rectification switching devices, each set of the at least one set of rectification switching devices corresponds to each of the at least one mains switching device in one-to-one correspondence, a mains fuse is connected in series between the first end of each of the at least one mains switching device and the corresponding coupled mains input terminal , and a battery fuse is connected in series between the second end of each of the at least one battery switching device and the corresponding coupled battery;
the adjusting of the operation state of the rectification and discharge multiplexing circuit based on the faulty switching device to cut off the fault circuit where the faulty switching device is located comprises:
turning on a set of rectification switching devices corresponding to the battery switching device to cut off the mains fuse corresponding to the battery switching device, in a case that the uninterruptible power supply operates in a mains mode and it is determined that the battery switching device is faulty;
turning on at least one set of rectification switching devices corresponding to the mains switching device to cut off the battery fuse, in a case that the uninterruptible power supply operates in a battery mode and it is determined that the mains switching device is faulty;
wherein the set of rectification switching devices corresponding to the battery switching device is a set of rectification switching devices corresponding to the mains switching device electrically connected to the battery switching device;
the mains fuse corresponding to the battery switching device is a mains fuse that is electrically connected to the mains switching device electrically connected to the battery switching device; and
the at least one set of rectification switching devices corresponding to the mains switching device comprises the battery fuse that is electrically connected to the battery switching device electrically connected to the mains switching device, and a battery fuse that is electrically connected to other battery switching device which is closed simultaneously with the battery switching device in the battery mode.

3. The method according to claim 1 or 2, wherein
the rectification and discharge multiplexing circuit comprises at least one rectification and discharge multiplexing unit, and the mains input terminal comprises three-phase mains terminal;
each of the at least one rectification and discharge multiplexing unit has three input terminals, each of the three input terminals is electrically connected to a second end of a mains switching device among three corresponding mains switching devices respectively, and a first end of the mains switching device among the three corresponding mains switching devices is coupled to a corresponding mains terminal of the three-phase mains terminal; and
the obtaining of the value of the current at at least one sampling point to-be-tested in the uninterruptible power supply comprises obtaining a value of a current at a first end of a mains switching device to-be-tested.

4. The method according to claim 3, wherein the obtaining of the value of the current at the first end of the mains switching device to-be-tested comprises:
for each of the at least one rectification and discharge multiplexing unit, obtaining a value of a current at the first end of the mains switching device to-be-tested among the three corresponding mains switching devices; and
wherein the determining that at least one switching device in the fault circuit to-be-detected is faulty in a case that the value of the current is within the fault current range corresponding to the at least one sampling point to-be-tested comprises:
determining that the battery switching device electrically connected to the mains switching device is faulty, in a case that the uninterruptible power supply operates in the mains mode and an absolute value of the value of the current at the first end of the mains switching device to-be-tested is greater than a first predetermined current value; and
determining that the mains switching device is faulty, in a case that the uninterruptible power supply operates in the battery mode and an absolute value of the value of the current at the first end of the mains switching device to-be-tested is greater than a second predetermined current value.

5. The method according to claim 3, wherein the obtaining of the value of the current at the first end of the mains switching device to-be-tested comprises:
obtaining values of currents at first ends of at least one set of mains switching devices to-be-tested, in a case that the rectification and discharge multiplexing circuit comprises at least two rectification and discharge multiplexing units;
wherein each set of the at least one set of mains switching devices comprises all the mains switching devices coupled to a same phase terminal of the three-phase mains terminal; and
wherein the determining that at least one switching device in the fault circuit to-be-detected is faulty in a case that the value of the current is within the fault current range corresponding to the at least one sampling point to-be-tested comprises:
for each set of the at least one set of mains switching devices, obtaining a minimum value among absolute values of values of currents at each mains switching device of the set of mains switching devices;
in a case that the uninterruptible power supply operates in the mains mode and a difference between an absolute value of the value of the current at at least one mains switching device and the minimum value is greater than a first predetermined difference, determining that a battery switching device electrically connected to the at least one mains switching device is faulty; and
in a case that the uninterruptible power supply operates in the battery mode and a difference between an absolute value of the value of the current at at least one mains switching device and the minimum value is greater than a second predetermined difference, determining that the at least one mains switching device is faulty.

6. The method according to claim 3, wherein the obtaining of the value of the current at the first end of the mains switching device to-be-tested comprises:
obtaining a value of a current at the corresponding mains terminal of the three-phase mains terminal coupled to the first end of the mains switching device to-be-tested; and
wherein the determining that at least one switching device in the fault circuit to-be-detected is faulty in a case that the value of the current is within the fault current range corresponding to the at least one sampling point to-be-tested comprises:
determining that at least one battery switching device corresponding to the corresponding mains terminal of the three-phase mains terminal is faulty in a case that the uninterruptible power supply operates in the mains mode and an absolute value of the value of the current at the corresponding mains terminal of the three-phase mains terminal is greater than a third predetermined current value, wherein the at least one battery switching device corresponding to the corresponding mains terminal of the three-phase mains terminal is electrically connected to the mains switching device coupled to the corresponding mains terminal of the three-phase mains terminal; and
determining that at least one mains switching device coupled to the corresponding mains terminal of the three-phase mains terminal is faulty in a case that the uninterruptible power supply operates in the battery mode and the absolute value of the value of the current at the corresponding mains terminal of the three-phase mains terminal is greater than a fourth predetermined current value.

7. The method according to claim 1 or 2, wherein
the rectification and discharge multiplexing circuit comprises at least one rectification and discharge multiplexing unit, each of the at least one rectification and discharge multiplexing unit has three input terminals, each of the three input terminals is electrically connected to a first end of three corresponding battery switching devices respectively, and a second end of the three corresponding battery switching devices is electrically connected to a positive electrode or a negative electrode of the battery; and
the obtaining of the value of the current at at least one sampling point to-be-tested in the uninterruptible power supply comprises obtaining a value of a current at the second end of a battery switching device to-be-tested.

8. The method according to claim 7, wherein the obtaining of the value of the current at the second end of the battery switching device to-be-tested comprises:
for each of the at least one rectification and discharge multiplexing unit, obtaining a value of a current at the second end of the battery switching device to-be-tested among the three corresponding battery switching devices;
wherein the determining that at least one switching device in the fault circuit to-be-detected is faulty in a case that the value of the current is within the fault current range corresponding to the at least one sampling point to-be-tested comprises:
determining that the battery switching device is faulty, in a case that the uninterruptible power supply operates in the mains mode and an absolute value of the value of the current at the second end of the battery switching device to-be-tested is greater than a fifth predetermined current value; and
determining that the mains switching device electrically connected to the battery switching device is faulty, in a case that the uninterruptible power supply operates in the battery mode and an absolute value of the value of the current at the second end of the battery switching device to-be-tested is greater than a sixth predetermined current value.

9. The method according to claim 7, wherein the obtaining of the value of the current at the second end of the battery switching device to-be-tested comprises:
obtaining values of currents at second ends of at least one set of battery switching devices to-be-tested, in a case that the rectification and discharge multiplexing circuit comprises at least two rectification and discharge multiplexing units;
wherein each set of the at least one set of battery switching devices comprises a first battery switching device electrically connected to the positive electrode of the battery and a second battery switching device electrically connected to the negative electrode of the battery; and
wherein the determining that at least one switching device in the fault circuit to-be-detected is faulty in a case that the value of the current is within the fault current range corresponding to the at least one sampling point to-be-tested comprises:
for each set of the at least one set of battery switching devices, calculating an absolute value of a sum of a value of a current at a second end of the first battery switching device and a value of a current at a second end of the second battery switching device;
determining that the first battery switching device and/or the second battery switching device are faulty, in a case that the uninterruptible power supply operates in the mains mode and the absolute value of the sum is greater than a seventh predetermined current value; and
determining that at least one mains switching device electrically connected to the set of the at least one set of battery switching devices is faulty, in a case that the uninterruptible power supply operates in the battery mode and the absolute value of the sum is greater than an eighth predetermined current value.

10. The method according to claim 7, wherein the uninterruptible power supply module further comprises a battery charging circuit, the positive electrode of the battery is electrically connected to a first end of the battery charging circuit through a first wire, the negative electrode of the battery is electrically connected to a second end of the battery charging circuit through a second wire, a second end of at least one first battery switching device is electrically connected to a first endpoint, the first endpoint is electrically connected to the first wire through a third wire, a second end of at least one second battery switching device is electrically connected to a second endpoint, and the second endpoint is electrically connected to the second wire through a fourth wire,
the obtaining of the value of the current at the second end of the battery switching device to-be-tested comprises:
obtaining a value of a current at the third wire and a value of a current at the fourth wire, wherein the at least one first battery switching device or the at least one second battery switching device comprises the battery switching device to-be-tested; and
wherein the determining that at least one switching device in the fault circuit to-be-detected is faulty in a case that the value of the current is within the fault current range corresponding to the at least one sampling point to-be-tested comprises:
calculating an absolute value of a sum of the value of the current at the third wire and the value of the current at the fourth wire;
determining that the first battery switching device and/or the second battery switching device are faulty, in a case that the uninterruptible power supply operates in the mains mode and the absolute value of the sum is greater than a ninth predetermined current value; and
determining that at least one mains switching device electrically connected to the first battery switching device and/or the second battery switching device is faulty, in a case that the uninterruptible power supply operates in the battery mode and the absolute value of the sum is greater than a tenth predetermined current value.

11. The method according to claim 1 or 2, wherein the uninterruptible power supply module further comprises a battery charging circuit, a positive electrode of the battery is electrically connected to a first end of the battery charging circuit through a first wire, a negative electrode of the battery is electrically connected to a second end of the battery charging circuit through a second wire, a second end of at least one first battery switching device is electrically connected to a first endpoint, the first endpoint is electrically connected to the first wire through a third wire, a second end of at least one second battery switching device is electrically connected to a second endpoint, and the second endpoint is electrically connected to the second wire through a fourth wire; and
the obtaining of the value of the current at at least one sampling point to-be-tested in the uninterruptible power supply comprises:
in a case that the uninterruptible power supply comprises at least two uninterruptible power supply modules, obtaining a value of a current on the first wire and/or the second wire in each of the uninterrupted power supply modules.

12. The method according to claim 11, wherein the determining that at least one switching device in the fault circuit to-be-detected is faulty in a case that the value of the current is within the fault current range corresponding to the at least one sampling point to-be-tested comprises:
obtaining a maximum normal operation current of each of the uninterruptible power supply modules;
for each of the uninterruptible power supply modules, determining that at least one battery switching device electrically connected to a target wire is faulty, in a case that the uninterruptible power supply module operates in the mains mode and an absolute value of a value of a current on the target wire is greater than the maximum normal operation current; and
for each of the uninterruptible power supply modules, determining that at least one mains switching device electrically connected to the target wire is faulty, in a case that the uninterruptible power supply module operates in the battery mode and the absolute value of the value of the current on the target wire is greater than the maximum normal operation current;
wherein the target wire comprises the first wire or the second wire.

13. The method according to claim 11, wherein
the current on the first wire is set to be a forward current and the current on the second wire is set to be a reverse current; and
the determining that at least one switching device in the fault circuit to-be-detected is faulty in a case that the value of the current is within the fault current range corresponding to the at least one sampling point to-be-tested comprises:
in a case that the uninterruptible power supply comprises at least three uninterruptible power supply modules and values of currents on the first wire and the second wire in each of the uninterrupted power supply modules are obtained, calculating a sum of the values of the currents on the first wire and the second wire in each of the uninterrupted power supply modules ;
determining that at least one switching device coupled to the first wire is faulty, in a case that the sum of the currents is greater than a first predetermined current sum;
determining that at least one switching device coupled to the second wire is faulty, in a case that the sum of the currents is less than a second predetermined current sum;
wherein the at least one switching device comprises the mains switching device or the battery switching device.

14. A fault detection and processing apparatus for an uninterruptible power supply, comprising:
an obtaining module configured to obtain a value of a current at at least one sampling point to-be-tested in the uninterruptible power supply, wherein the at least one sampling point to-be-tested is located in at least one fault circuit to-be-detected of the uninterruptible power supply, and each of the at least one fault circuit to-be-detected comprises at least one mains switching device and at least one battery switching device; and
a processing module configured to determine that at least one switching device in the fault circuit to-be-detected is faulty, in a case that the value of the current is within a fault current range corresponding to the at least one sampling point to-be-tested, and adjust an operation state of a rectification and discharge multiplexing circuit based on the faulty switching device, to cut off the faulty circuit where the faulty switching device is located.

15. A controller, comprising:
a processor; and
a memory connected in communication with the processor; wherein
the memory stores computer executable instructions; and
the processor is configured to, when executing the computer executable instructions, perform the method according to any one of claims 1 to 13.
